# EUROPEAN PATENT SPECIFICATION

(11) **EP 4 001 971 B1**
(45) Date of publication and mention of the grant of the patent: **23.10.2024**
(21) Application number: 20382974.2
(22) Date of filing: 11.11.2020
(51) Int. Cl.: G06F 30/20, G01V 99/00, G06F 30/23

(54) **COMPUTER IMPLEMENTED METHOD FOR MANIPULATING A MESH FOR THE DISCRETIZATION OF A RESERVOIR DOMAIN**
COMPUTER-IMPLEMENTIERTES VERFAHREN ZUR MANIPULATIONS EINES NUMERISCHEN GITTERS FÜR DIE DISKRETISIERUNG EINER LAGERSTÄTTE
PROCÉDÉ IMPLEMENTER SUR UN ORDINATEUR POUR MANIPULER UNE GRILLE NUMÉRIQUE POUR DÉSCRITESER UN DOMAIN DE RÉSERVOIR

(43) Date of publication of application: 25.05.2022
(73) Proprietor: Repsol, S.A., 28045 Madrid (ES)
(72) Inventor: VARGAS MENDOZA, Pablo Enrique, 28935 Móstoles, Madrid (ES); GONZÁLEZ MOLANO, Nubia Aurora, 28935 Móstoles, Madrid (ES); PÉREZ, Juan Manuel, 28027 Madrid (ES); GIMÉNEZ, Javier, 28027 Madrid (ES); SEGURA SERRA, José María, 28935 Móstoles, Madrid (ES); IBÁÑEZ MARTÍNEZ, Enric, 28935 Móstoles, Madrid (ES); ALVARELLOS IGLESIAS, José, 28935 Móstoles, Madrid (ES); MOLINOS, Roberto, 28027 Madrid (ES); MOOKANAHALLIPATNA RAMASESHA, Lakshmikantha, 28935 Móstoles, Madrid (ES)
(74) Representative: ABG Intellectual Property Law, S.L.

(56) References cited:
- US-A1- 2012 296 619
- US-A1- 2014 222 403
- US-A1- 2018 322 232
- US-A1- 2018 347 320
- LONGMIN RAN ET AL: "Hex-dominant mesh generation for basin modeling with complex geometry", IOP CONFERENCE SERIES: MATERIALS SCIENCE AND ENGINEERING, INSTITUTE OF PHYSICS PUBLISHING LTD, GB, vol. 10, 1 January 2010 (2010-01-01), pages 1 - 10, XP007918465, ISSN: 1757-8981, [retrieved on 20100705], DOI: 10.1088/1757-899X/10/1/012085

## Description

### FIELD OF THE INVENTION

The present invention is related to a computer-implemented method for manipulating a mesh for the discretization of a reservoir domain, the reservoir domain modeled by a geophysical model, a fluid model, or both models.

The method is characterized by the use of cells partitioning the reservoir domain wherein each cell comprises a numerical mesh. The mesh of the reservoir domain is the union of the meshes located in the plurality of cells.

The partitioning of the domain into a plurality of cells allows easy modification of specific regions of the domain wherein re-meshing requirements are limited to those cells housing modified elements and maybe some surrounding cells.

### PRIOR ART

The simulation of physical entities is one of the technical fields with more intensive development. In most cases, the physical entity is a piece or a device. Manufacturing the physical entity is expensive and, if the final result is not satisfactory then a new physical entity must be manufactured again.

Even when it is possible to manufacture the physical entity, there are some measurements that cannot be measured and the prototype is not useful. This is the case where the location of the measurement is not accessible or the instrument for the measurement is intrusive.

The exploitation of oil and gas reservoirs is even more complex since the measurements at any point of the reservoir are unaffordable and, in any case, the measurements with probes or perforating techniques are clearly intrusive modifying the measured value.

As an example, the simulation of oil and gas reservoirs allows obtaining measurements at any location of the simulated domain and, reproducing an exploitation process as many times as needed for identifying the optimal exploitation plan.

Additionally, many of the geological features and fluid-related features are determined by using computational techniques processing data previously acquired on the field. This is the case of numerical models provided by migrating acoustic data or populated with properties determined by using electromagnetic measurements.

In these cases, the subsequent process requires numerical models that are numerically modeled for simulating the behavior of the reservoir.

Specific numerical methods typically used for simulating oil and gas reservoirs are finite-element methods or finite-volume methods.

When solving the governing equations for simulating the reservoir domain, a first step discretizing the domain is required.

Generating a discretization of a reservoir domain is a complex process that may require several days for an expert to provide a reliable numerical model that is suitable for being processed in a subsequent step. The huge amount of geophysical entities such as discontinuities like faults, folds, fractures, fissure or bedding planes, geological formations comprising material layers, or the presence of complex geometries result in a complex process requiring many hours of work for an expert.

The most common reservoir domains may be modeled by a geophysical model, said model comprising geophysical entities and properties such as rock properties, shapes, stratigraphic properties, faults, discontinuities, fractures, porosity, etc.; a fluid model, said model comprising fluid properties, the composition of mixed fluids, pressure values, regions being occupied by the fluid, etc.; or both models.

In most of the cases, additional data obtained from other sources of information requires changes on any of the two models. When a numerical mesh is generated discretizing the geophysical model, the fluid model or both models said mesh is adapted to the properties and physical entities represented by said models.

Some well-known automatic mesh-refining techniques are based on generating a finer mesh on those parts where the error is estimated over a predetermined threshold. These techniques require an error estimator since the exact solution of the governing equations are not available. In these cases, for instance using finite-elements or finite-volumes, just as an example, are divided and the nodes renumbered.

In many cases, the automatic mesh-refining requires the manipulation of the user who checks whether the proposed mesh is adequate or, if a mesh-refining must be forced in some specific region.

Once the mesh is adapted to the geophysical model or the fluid model, the nodes of the mesh are located on specific locations imposed by the shape and location of the geophysical elements or properties of the models. As a result, any change of the numerical model or the fluid model causes that the entire mesh must be generated from scratch wasting all the previous work of the user.

It is known the US patent application No. US2014/0222403A1 disclosing a method that includes formulating a linear system of equations for an implicit function with respect to a mesh that represents a geologic environment; solving the linear system of equations as a first sub-system subject to at least one second order smoothness constraints and at least a portion of data and as a second sub-system subject to al least one first order smoothness constraint and at least a portion of the data; and, based at least in part on the solving, outputting values for the implicit function with respect to at least a portion of the mesh.

It is also known the US patent application No. US2018/0347320A1 that discloses a method for generating a geologic structural model.

It is also known the US patent application No. US2012/0296619A1 disclosing a method and a system for partitioning parallel simulation models.

It is also known the US patent application No. US2018/0322232A1 a method for representing structural uncertainty in a mesh representing a geological environment.

It is also known the publication "Hex-dominant mesh generation for basin modeling with complex geometry", IOP Conf. Series: Materials Science and Engineering 10 (2010)".

The present invention is a computer-implemented method that overcomes all the identified drawbacks facilitating the modification of specific regions of the domain while keeping the mesh already generated in the rest of the domain. The invention comprises cells partitioning the domain wherein each cell has associated a mesh. The discretization of the reservoir domain is determined by the union of the meshes located in all cells.

### DESCRIPTION OF THE INVENTION

The present invention is *a computer implemented method for manipulating a mesh for the discretization of a reservoir domain modeled by a geophysical model, a fluid model or both models, wherein the geophysical model comprises the mechanical and rock properties and the fluid model comprises the fluid properties and, both models comprise geophysical entities of the reservoir, the information data of geophysical entities being retrieved from the reservoir,*
*the method comprising:*
*a) generating, via a computer system, a geophysical model, a fluid model or both models, said models comprising geophysical entities in the domain.*

The geophysical model comprises the mechanical and rock properties and the fluid model comprises the fluid properties and, both models geophysical entities of the reservoir. Examples of properties and entities are: layers, rock properties, the shape and location of faults and fractures, discontinuities of the properties, porosity, fluid properties and composition, saturation, well locations, etc. These geophysical entities has associated a specific location that may be stored as a point, a set of locations according to a straight or to a curved line, a surface or a volume.

Throughout all this document, "geophysical entities" should be understood as any natural or artificial entities comprised in the reservoir domain that imposes a restriction conditioning the mesh structure.

The method further comprises:
*b) generating, via a computer system, a partition of the domain, the partition comprising a plurality of cells limited by a boundary, each cell comprising vertices and, each cell has a common boundary with adjacent cells.*

The partition of the domain allows limiting the influence of modifications on specific regions of the domain. According to specific embodiments, each cell may be additionally partitioned in such a way it houses a plurality of cells. When a cell is partitioned into smaller cells, the number of elements or geophysical entities found within the partitioned cells is less ensuring a resulting mesh generated at a later stage to be simple while adapted at a high resolution to the entities of the geophysical and fluid models.

A sub-cell is a cell resulting from a subdivision of a larger cell, nonetheless, it is also a cell. Throughout the description, when referring to a cell, it may also be applied to a sub-cell unless the contrary is explicitly disclosed.

The method additionally comprises:
*c) generating for each cell, via a computer system, a numerical mesh discretizing the cell, said numerical mesh comprising nodes at least in the vertices of the cell;*
d) *providing the mesh resulting from the union of the meshes of the plurality of cells, that is, the result of a consolidation process removing the duplicated nodes of adjacent cells and to store the nodes in the global mesh only once wherein duplicated nodes are of locations separated by a distance lower than a predetermined threshold;*
*wherein the cells (C) of the partition (P), have a shape that, when a cell (C) is subdivided into smaller sub-cells (C), said sub-cells (C) have the same topology than the original (C), and wherein the set of cells (C) are rectangles if the domain (Ω) is a 2D-domain or hexahedrons if the domain (Ω) is a 3D-domain, with the edges*/*faces parallel two by two;*
*the method being adapted for the simulation of oil and gas reservoirs, reproducing an exploitation process as many times as needed for identifying the optimal exploitation plan, said optimal plan being the exploitation plan of the exploitation process.*

Given the partition of the reservoir domain, a mesh generation is executed for each cell. Since the mesh generation requires that the generated mesh comprises nodes at least in the vertices of the cell, the configuration of the resulting mesh is conditioned by the cell partition.

A mesh of a cell may comprise additional nodes; this is the case where an adjacent cell, that is, those cells having a common boundary resulting from the partitioning process, has been further partitioned and a boundary is limited by a boundary of the cell but is not located in a vertex of the cell. Additional nodes may be added if needed.

According to a specific embodiment, the partition generating cells provides a structured partitioning while the mesh generated in at least one cell is unstructured resulting in an unstructured global mesh.

The resulting mesh of the method may be sent to the solver with no need of sending the cell partitioning. Nonetheless, the cell partitioning may be stored for subsequent refinements wherein the mesh may be modified in view of the resulting values of the simulation or further modifications of the geophysical model or the fluid model.

In a preferred global context of the invention, data retrieved from a reservoir provides information of geophysical entities in said reservoir allowing to simulate the reservoir by numerical simulators based on the use of a mesh approximating the representation of the geophysical entities and the geophysical and fluid properties. Once the mesh is generated according to the invention by a computer system, the numerical simulator process such an information also in a computer system providing the behavior of the geophysical model, the fluid model or both.

When a cell is partitioned into sub-cells under a certain criteria the term refined or refined cell will be used.

According to the invention, sub-cells has the same topology of the divided cell ensuring in an initially structured partition that the resulting partitioning may be recursively stored according to pre-stablished rules facilitating the indexing process of each new cell.

Another advantage of the invention is that the meshing procedure may be based on a plurality of conditions that may be reproduced in any of the cells or sub-cells and therefore no new scenarios or conditions are generated making the implementation process easier and very robust.

According to specific embodiments, *for each common boundary between a cell and an adjacent cell, vertices of the cell limiting the common boundary are nodes of the mesh of the adjacent cell.*

When a mesh located in a cell and a mesh located in an adjacent cell has a common node according to a preferred embodiment the node is stored only once. In specific implementations of the method duplicated nodes are simplified keeping only a single node and a node renumbering process executed. The same applies when duplicated nodes are at locations slightly separated by a distance under a predetermined threshold.

Preferably, in all the embodiments, the meshing is performed at individual cell level.

Once the cells are meshed, the global mesh of the reservoir domain is the result from the union of the individual meshes and, therefore, a consolidation process is performed in order to remove the duplicated nodes of adjacent cells and to store the nodes in the global mesh only once.

According to another embodiment, *given a predetermined cell, those nodes of the mesh of adjacent cells located at the common boundary between the cell and the adjacent cell are also nodes of the mesh of the cell.*

Under this condition, when surrounding cells are the result of a subdivision, additional vertices are generated and therefore additional nodes will be used in the resulting meshes in the sub-cells. These new nodes are also nodes of the mesh of the adjacent cells ensuring a coherent global mesh.

*According to a specific embodiment,* each cell comprises a plurality of active points at a predetermined locations of the boundary of the cell, being the active points the points of the cell that are candidate locations allowed to be a node of the mesh.

Once the reservoir domain is partitioned, the shape of the cells define the active points of the cells. The active points of a cell are relevant points of the boundaries of the cell that are candidates to be a node of the mesh generated in a subsequent step.

Once the shape of the cells has been determined, the active points associated to said shape of cell are also predetermined.

According to a specific embodiment, in a 2D-domain the active points of the cells are the vertices of the cell and the midpoints of each edge of the cell, in a 3D-domain the active points of the cells are the vertices of the cell, the midpoints of each edge of the cell and the barycenter of each face of the cell.

Throughout all this document, "nodes" should be understood as the active points of each cell that are used in the subsequently generated mesh of the cell, being at least the vertices of the cells.

According to another embodiment, *a cell or a sub-cell of the partition is refined by subdividing each dimension into two parts by half resulting* 2*^{N} sub-cells where N is the number of dimensions, the new sub-cells being part of the partition.*

If the shape of a cell is a rectangle in a 2D domain, a refinement process over this cell comprises subdividing each of the two dimension into two parts by half in this case resulting four rectangles.

Dividing each dimension by half is a constraint determining the subdivision process resulting in a plurality of smaller sub-cells that keeps the rate between two or more dimensions and therefore no progressively stretched sub-cells are generated.

This constraint keeps good properties for the resulting mesh generated when generating a mesh in each sub-cell.

According to an embodiment, *if a cell being subdivided has a mesh, said mesh is removed before subdividing the cell and a new mesh is reconstructed at least in the new sub-cells after subdividing the cell.*

In this embodiment, a refinement of at least one cell is required for instance due to a better resolution is required because of the presence of a plurality of elements or geophysical entities of any of the models, the geophysical model or the fluid model. Then, the mesh of the cell to be subdivided is removed. The cell devoid of the mesh is refined generating new sub-cells. Once the refinement has finished, the mesh generation process may start for each sub-cell or cell being amended.

In the following, several criteria is defined determining triggering conditions for refining cells. These criteria may comprise additional specific criteria for certain model. According to a preferred embodiment, the criteria is checked in each of the cells.

According to an embodiment, *a cell is refined under a first criterion based on the number of divisions of the adjacent cells, that is, the cell is refined if the number of divisions of the adjacent cells in the common boundary is greater than a predetermined value, preferably 2.*

This criterion ensures that between big cells and small cells a transition is generated when said criterion is applied iteratively wherein the size of the cells is progressively adapted between the two sizes. When reaching this transition, the generated mesh based on the resulting cells fulfills the condition of being also a smooth transition improving the behavior of the resulting discretization when used by a solver while keeping non-distorted shapes for the mesh.

If this criterion is fulfilled triggering a refining process, this process is also bounded in space so it does not imply that the entire domain must be re-meshed resulting in a limited influence of the refining process.

According to an embodiment, *a cell is refined under a second criterion based on the number of entities housed in the cell, that is, the cell is refined if the number of geophysical entities housed or partially housed in the cell is greater than a predetermined value, preferably 2.*

This second criterion is based on the number of entities housed in the cell. The term entities may refer to geophysical entities, fluid entities or even discontinuities on the physical properties. That is, the interface located in the discontinuity is also interpreted as an entity. An entity may be entirely housed or partially housed in a cell. If the entity is at least partially housed it is deemed to be housed and it is taken into account when counting the number of entities within the cell.

This criterion limits the number of the entities located within a cell providing a better mesh resolution based on the cell generation for regions comprising a plurality of entities.

According to an embodiment, *a cell is refined under a third criterion based on the distance of the intersection of a geophysical entity, at least partially housed in the cell, with the boundaries of the cell and the active points of said cell, that is, the cell is refined if the minimum distance between the intersection of a geophysical entity with the boundaries and the active points of said cell is greater than a predetermined value.*

A cell comprises a plurality of active points, vertices and possible nodes of the mesh, wherein each vertex is at least a node. When a geophysical entity is partially housed in the cell, the intersection of said geophysical entity shows a distance with each active point of the cell since only active points are locations of the cell where the node is allowed to be located. If said minimum value is greater than a predetermined value the cell is refined causing the subdivision of it.

This third criterion allows to locate new vertices and active points due to the subdivision of the cell, and therefore to locate nodes of the mesh, at a distance of the geophysical entity less than said predetermined value. The resulting mesh fulfill the same condition.

In a referred embodiment, the geophysical entities of the reservoir domain are represented by approximating the geometry of the entities by sections along the cells.

According to a specific embodiment, in a 2D-domain the approximation of the geometry of the entities gives rise to broken line. In a 3D-domain the approximation of the geometry of the entities gives rise to portions of ruled surfaces.

The active points are the points used to approximate the geometry of the geophysical entities. If there is a geophysical entity at least partially housed in a cell, the active points of said cell are candidates to represent the geometry of the geophysical entity housed in the cell. From the active points of the cell, the nearest active point or points is/are selected to represent the approximate geophysical entity. If the distance between the intersection of said geophysical entity and the closest active point is higher than the predetermined value, the cell is refined and new active points for each sub-cell are considered in order to achieve a better approximation of the geophysical entity.

According to this embodiment, the nodes of the mesh are all the vertices of the cells and those active points that are representing a geophysical entity. The vertices of the cells are deemed as active points.

According to an embodiment, *the cells of the partition are iteratively subdivided until none of the three criteria is fulfilled.*

According to this embodiment, at the end of the iterative process the resulting partition of the domain has been checked against all of the three refinement criteria. Additionally, if the geophysical model or the fluid model is modified, the iterative process will reach again a partition adapted to approximate accurately enough the two models.

According to an embodiment, the implemented method in a computer, under a modification of any of the models, sends a signal wherein each cell checks if at least the first, second and third criteria is fulfilled triggering a refinement process if any of said criteria is fulfilled.

Once all the criteria are not fulfilled, each refined cell may be re-meshed.

According to an embodiment, *in each refining operation of cells, in those common boundaries of a cell adjacent to cell boundaries limiting two or more sub-cells the method further adds at least a new node of the location of the intersection of the common boundary of the cell and the boundaries limiting the two or more sub-cells.*

When a cell has two or more adjacent sub-cells being the result of a refined process and shows cell boundaries of the subdivision being limited by the boundary of the cell where no vertices are located, then at least one node is added. That is, such location is processed as having an active point.

According to this condition, those new vertices generated during the refining process that are located in the boundary of a larger cell and is not a vertex of said cell then this condition generates a new node making the resulting meshes in all the cells involved in the refinement process fully connected.

Once all nodes are generated after a mesh generation or a refinement, if the application of the mesh generation is further a finite element discretization or a finite volume discretization, nodes are connected ensuring that said connection provides closed polygons in 2D domains or closed regions in 3D domains. This constraint ensures that each resulting element if the application is a finite element discretization or each volume if the application is a finite volume discretization, is contained in one entity.

According to preferred embodiments, *a geophysical entity comprises shape properties delimiting the geophysical entity, being such properties among:*
- *a line shape,*
- *a surface shape,*
- *volume shape,*
- *a zero-thickness interface,*
- *a combination or union of any of previous shape properties.*

An specific entity is a zero-thickness interface element modeling faults, natural fractures or bedding planes. It may also be used for induced fractures also named as hydraulic fractures. In a two-dimensional domain the shape property of a zero-thickness interface is a line and, in a three-dimensional domain the shape property is a surface. Zero-thickness interface elements are disclosed in the patent application Nº WO2015/124633A1. Said zero-thickness interface elements are used for modeling geological discontinuities that may evolve for instance generating a separation between two surfaces wherein double-nodes are then separated in such a way one of the two nodes are located in one surface and the other node is located in the opposite surface.

When zero-thickness interface elements are used, consolidation processes directed to remove double nodes of meshes generated on different cells do not act over the double nodes of zero-thickness interface elements.

According to an embodiment, *after generating the partition or after generating the partition and one or more meshes in cells, the method comprises:*
- *modifying the geophysical model, the fluid model or both models,*
- *identifying at least one updated cell, that is, a cell housing geophysical entities with modified data;*
- *removing the at least one updated cell from the partition;*
- *filling the space of the domain with a new cell or cells.*

The term "modifying" is interpreted in a generic manner wherein addition, modification or the removal of an entity are deemed a modification of the geophysical model or the fluid model.

This modification changes the properties of a region of the domain. Those cells housing at least part of said modified region are removed from the partition and, the void space is filled with a new cell or cells.

This process generating new cells may trigger an automatic checking process wherein the at least first criteria, second criteria or third refinement criteria, or any combination thereof is checked and a cell refining process is started if any of the identified options are met. The optimal refinement is obtained when at least the three criteria are checked and none of them is fulfilled.

This condition is expressed with "may" since the checking process is not applied for instance when additional modifications are required as a checking process before ending the modifications would waist computational resources.

According to an embodiment, the refinement triggering event is a signal of the cell or cells causing to process the cells to be refined. This embodiment may be preferably implemented by using an object-oriented paradigm.

According to an embodiment, *each cell further stores data of the geophysical entities being housed in said cell.*

When a cell is removed and replaced by a new cell or cells because a re-meshing operation, the entities of the first cell can be temporally stored and transferred to the new cells. Additionally, according to other embodiment, when a cell is sub-divided into a plurality of sub-cells, the data stored in the cell before being sub-divided is stored in the new sub-cells wherein each sub-cell stores only the relevant data for it. According to an alternative embodiment, if a cell is removed and replaced by a new cell or cells because the information regarding the entities changes then the removal of the cell or cells also comprises the removal of the entities and their replacement if any.

The entities comprised in a cell can be removed or modified and new entities can be added, then, the updated cell or cells are removed and replaced by the new cells comprising the updated entities.

As it has been disclosed, *according to another embodiment, wherein after filing the space of the domain with a new cell or new cells,*
- *the new cell or cells are refined,*
- *a new mesh is generated in each updated cell or cells; and*
- *the mesh is updated if needed.*

Once the updated cells are replaced by the new cells, the cells are refined, checking if the first or the second or the third refinement criterion or any combination thereof are met. When all the cells are refined, the mesh for each updated cell is generated and the global mesh is updated.

At least former criteria, first criterion, second criterion and third criterion, provide conditions for sub-dividing cells wherein the use of an iterative process until none of the criteria are met ensures a progressive refinement of the cells. Once the cells are refined, those cells devoid of a mesh, when checked, triggers a meshing generation.

Those cells already meshed but having additional nodes are re-meshed wherein the new mesh comprises at least all vertices of the cell and also the new nodes not being located at any vertex.

It is also an aspect of the invention *a computer readable medium storing computer-executable instructions which, when executed by a processor, result in the method according to any of the previous embodiments.*

The generic term "processor" may be implemented by using a multi-processor system, for instance implementing a parallel computing process.

It is also an aspect of the invention *an electronic device for data analysis, the device comprising:*
- *a processor; and*
- *a computer readable medium storing computer-executable instructions which, when executed by the processor, result in the method according to any of the previous embodiments.*

### DESCRIPTION OF THE DRAWINGS

These and other features and advantages of the invention will be seen more clearly from the following detailed description of a preferred embodiment provided only by way of illustrative and non-limiting example in reference to the attached drawings.
- Figure 1: This figure shows an example of a reservoir domain.
- Figure 2: This figure shows a partition of the reservoir domain in cells.
- Figure 3: This figure shows a global mesh resulting from the union of the meshes of each cell according to the previous partition.
- Figure 4: This figure shows another example of a reservoir domain.
- Figures 5A-5D: These figures show a partition and refinement steps of the previous reservoir domain according to an embodiment of the method of the invention.
- Figures 6A-6B: These figures show a representation of the geometry of the geophysical entities according to the previous partition.
- Figures 7A-7C: These figures show the global mesh resulting from the partition of the reservoir domain.
- Figures 8A-8B: These figures show an example of a block to replace a set of cells of the reservoir domain and the partition of said block.
- Figures 9A-9B: These figures show the replacement of the set of cells of the previous example in the reservoir domain.
- Figure 10: This figure shows the global mesh of the domain according to the replacement of the previous example.
- Figures 11A-11C: These figures show a 3D-domain example with its corresponding partition in a plurality of cells.

### DETAILED DESCRIPTION OF THE INVENTION

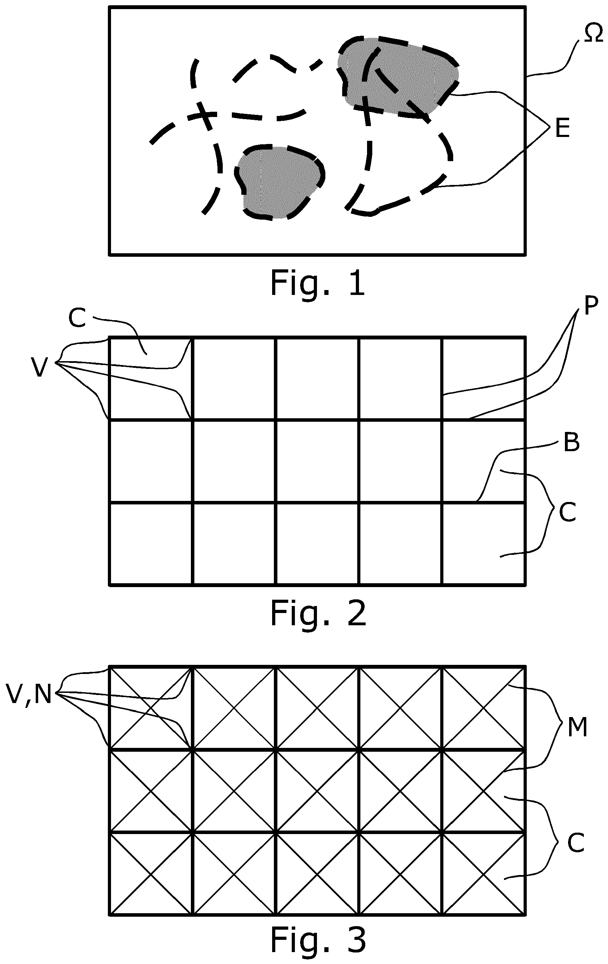

Figure 1 shows an example of a reservoir domain (Ω) modeled by a geophysical and fluid model (GM, FM). This figure represents an example of a 2D-domain.

In figure 1 some entities (E) are located in the reservoir domain (Ω). The entities (E) represented by dashed lines corresponds to geophysical entities (E) such as faults, layers, etc. There are some shaded areas in figure 1 that determine areas of the domain with different facies properties, and the dashed lines limiting the shaded areas represent the discontinuities of the properties from different areas. The facies are the characteristics of a rock unit that reflect its origin and permit its differentiation from other rock units around it. Facies usually are characterized using all the geological characteristics known for that rock unit.

Figure 2 shows the reservoir domain (Ω) of the example of figure 1 partitioned. According to the method of the present invention, the domain (Ω) of this example is partitioned into a plurality of cells (C). In this example, the partition (P) comprises a plurality of square-shaped cells (C) with the edges parallel two by two. Each cell (C) is limited by a boundary (B) and has four vertices (V). Cells (C) that are next to each other are adjacent cells (C) that have common boundaries (B).

Figure 3 shows the meshes (M) discretizing each cell (C) of the partition (P) from figure 2. Once the domain (Ω) is partitioned, a mesh (M) is generated for each cell (C). In this example, the nodes (N) of the meshes (M) are the four vertices (V) of each cell (C). Therefore, the mesh (M) for each cell (C) is represented in figure 3 by two lines, each line connecting a vertex (V) of the cell (C) to the opposite vertex (V) resulting in a five nodes mesh since a central nodes has been added.

According to this embodiment, once a plurality of active points (A) of each cell (C) are selected to be a node (N) of the mesh (M), the algorithm generating the mesh (M) allows to add additional nodes (N). In view of the mesh (M) shown in figure 3, the algorithm used for generating the mesh (M) adds additional nodes located in the center of each cell (C).

The mesh (M) of the reservoir domain (Ω) of the example, the global mesh (M), is the union of the individual meshes (M) generated for each cell among the plurality of square-shaped cells (C).

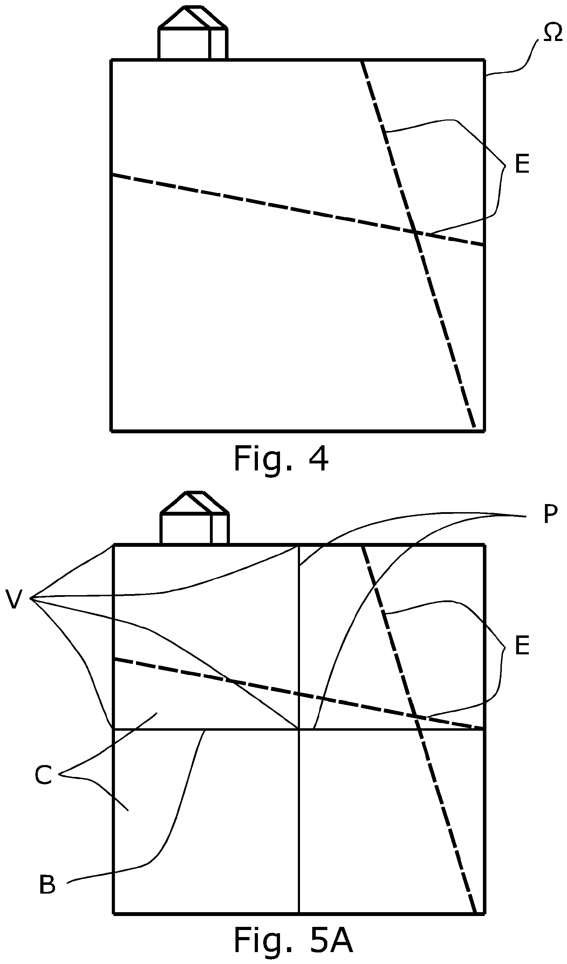

Figure 4 shows another example of a reservoir domain (Ω). The figure shows a 2D-domain. In the figure two geophysical entities (E) are shown. The geophysical entities (E) are represented by two dashed lines. The geophysical entities (E) contained in the reservoir domain (Ω) of this example can be, for example, horizons, faults or fractures.

Figures 5A to 5D show the partition process of the reservoir domain (Ω) shown in figure 4. In the partition process, the domain (Ω) is partitioned into a plurality of cells (C). Each cell (C) comprises vertices (V) and is limited by a boundary (B).

In this 2D-domain example, the cells (C) have a square shape with the edges parallel two by two. Figures 5A to 5D show that each cell (C) or sub-cell (C) is refined by subdividing each dimension into two parts by half resulting four sub-cells (C) in each partition of each cell (C) or sub-cell (C). When each cell (C) is subdivided into smaller sub-cells (C), said sub-cells (C) have the same topology than the original cell (C). As it can be seen in the figures, in this example, the shape of the cells are squares.

Figure 5A shows the first subdivision in four regular sub-cells (C) of the whole reservoir domain (Ω) shown in figure 4. In the following figures (5B, 5C and 5D) the next steps of the refinement of the cells are shown.

The refinement process consist on the subdivision of the cells (C) according to some criteria. In this example, for each cell (C) that contains more than two geophysical entities (E) a subdivision in four sub-cells (C) is performed until each cell (C) contains two geophysical entities (E) or less. Also, enforce adjacent cell size relations of most 2:1 ratio, that is, a cell (C) is refined if the number of divisions of the adjacent cells (C) in the common boundary (B) is greater than two. Each cell (C) is subdivided into smaller sub-cells (C) until the relation with adjacent cells (C) is at most 2:1.

Figures 5A to 5D show another criterion based on the distance of the intersection of each geophysical entity (E) housed in a cell (C) with the edges of the cell (C) and the active points (A) of said cell (C).

The active points (A) of each cell (C) are the points of the cell (C) that are candidates to be a node (N) of the mesh (M). The square shape of the cells (C) define the active points of each cell (C) wherein in this embodiment the active points are the vertices of the cell (C) and the midpoints of each edge of the cell (C).

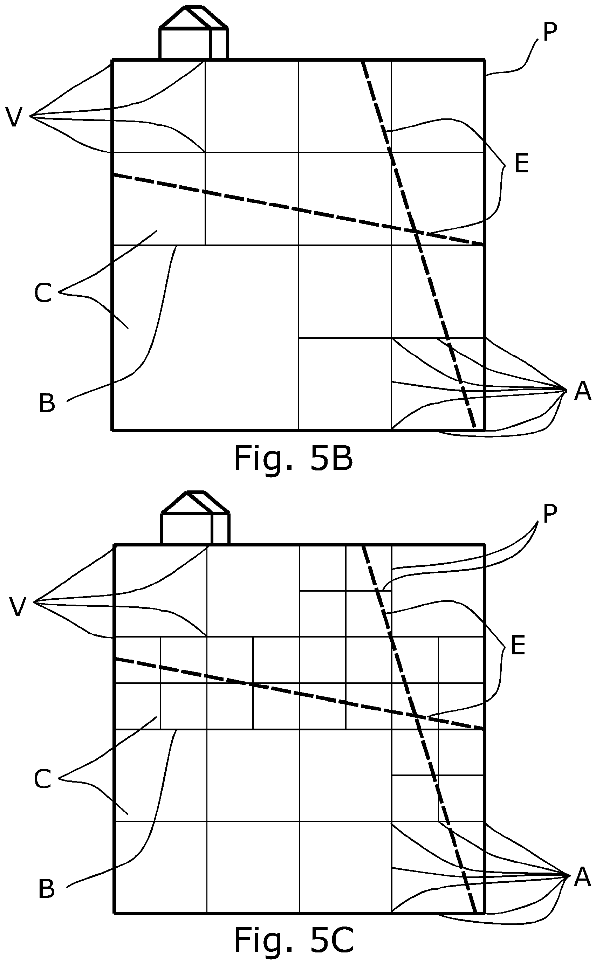

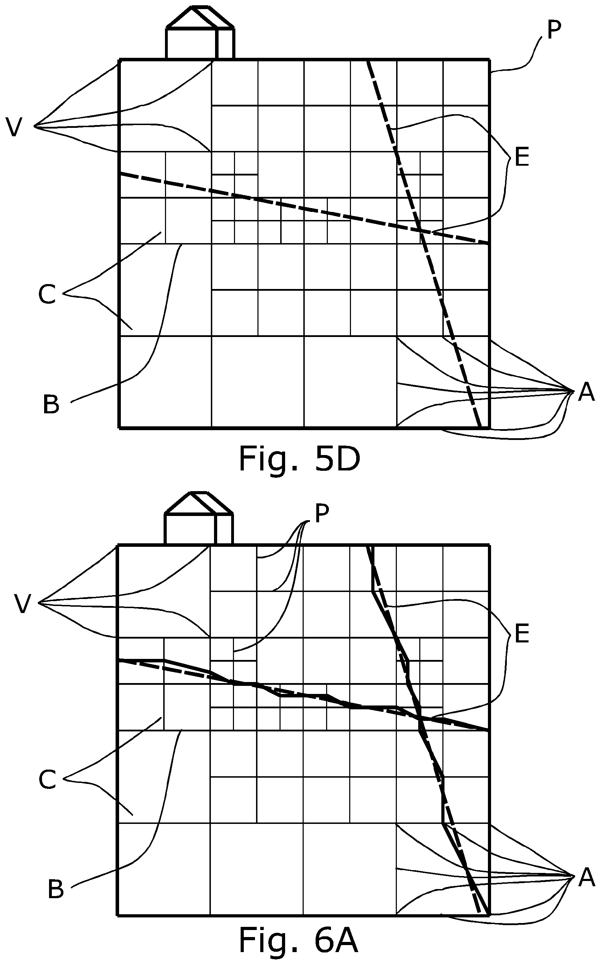

In this embodiment, from the partition (P) of figure 5A to the next partition (P) of figure 5B, a subdivision of three cells (C) is performed in order to refine each cell (C) reducing the distance between the intersection of the geophysical entities (E) with the boundaries (B) and the active points (A) of each cell (C). Figures 5C and 5D show the following divisions of the cells (C) reducing the distance until the geophysical entities (E) complies the tolerance distance with the active points (A).

The cells (C) are subdivided until the criterion of the number of geophysical entities (E) housed in each cell (C), the criterion of the size relations between adjacent cells (C) and the criterion of the distance between the geophysical entities (E) and the active points (A) are not fulfilled.

For instance, the cell (C) located at the bottom and left side in figure 5A does not comprise any geophysical entity (E) and therefore it does no need to be sub-divided as shown in figure 5B. The other three sub-cells are divided since they houses at least one geophysical entity (E).

In view of the refinement shown in figure 5B, those sub-cells housing at least one geophysical entity are refined generating new sub-cells due to at least one criterion is meet resulting the refinement shown in figure 5C. In figure 5C, the cell (C) located at the bottom and the left side has been refined even if it does not house any geophysical entity (E) since the neighboring cells located in the upper part have been refined twice and therefore it meets the criterion of having the upper boundary the maximum aspect ratio with neighbor cells, in this case 2:1.

Specifically in figure 5C, in each sub-cell housing at least a portion of a geophysical entity (E), the distance of said portion to the plurality of active points of the sub-cell is measured. When the distance is greater than a predetermined value the sub-cell is refined into four sub-cells again as shown in figure 5D where no additional refinements are required.

Once the conditions above are not met and the refinement of the partition (P) of the reservoir domain (Ω) is completed, the geometry of the geophysical entities (E) housed in the cells (C) is approximated by the closest active points (A) of the final cell (C) structure.

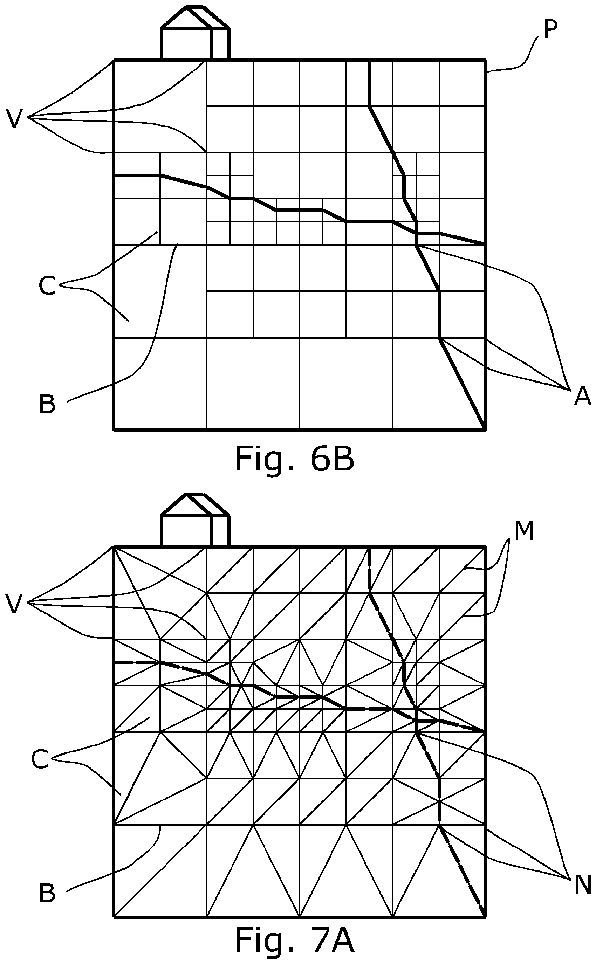

Figures 6A and 6B show an approximation of the geometry using thick continuous lines of the geophysical entities (E) according to the previous partition (P) superimposed to the shape of the geophysical entities (E) represented by thick dashed lines.

The active points (A) of a cell (C) are candidates to represent the geometry of the geophysical entities (E) housed in a cell (C). The geophysical entities (E) are represented by portions of segments between active points (A) in each cell (C). From the active points (A) of the cell (C), the nearest active point (A) to the intersection of the geophysical entity (E) with the boundaries (B) is selected to approximate the geophysical entity (E).

The active points (A) selected to represent the geophysical entities (E) are nodes (N) that must be included in the mesh (M) that is generated in the next step.

As it has been indicated, the thick dashed lines in figure 6A represent the geophysical entities (E) of the reservoir domain (Ω) and the thick continuous lines in figure 6A represent the approximation of the geophysical entities (E) by straight segments between active points (A) in each cell (C). Figure 6B shows the partition (P) of the reservoir domain (Ω) and the representation of the geophysical entities (E) of the reservoir domain (Ω) according to the approximation provided by the active points (A) of the cells (C) of the partition (P).

Once the approximated geometry of the geophysical entities (E) is created, each cell (C) is individually meshed.

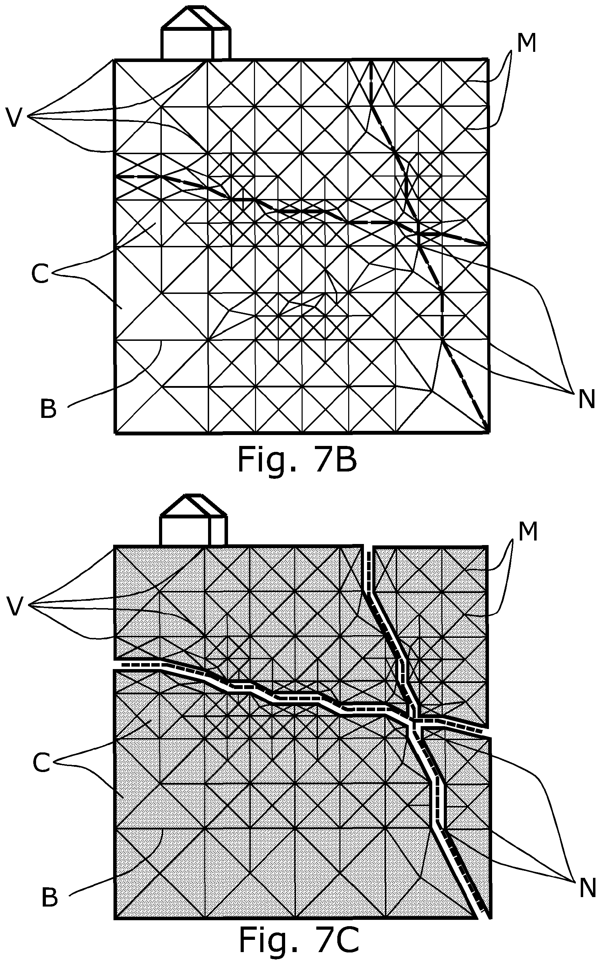

Figures 7A and 7B show the resulting numerical mesh (M) of each cell (C) according to two different algorithms under the constraint of at least comprising the vertex of the cell and those active points used for approximating the geophysical entities (E). Figure 7A show the resulting numerical mesh (M) using the "Delaunay" algorithm and Figure 7B shows the resulting numerical mesh (M) using the "Centroid" based algorithm.

The mesh (M) of each cell (C) comprises nodes (N) in the vertices (V) of the cell (C) and in those active points (A) used to represent the geophysical entities (E) housed in the cell (C). The vertices (V) of a cell (C) limiting a common boundary (B) with an adjacent cell (C) are also nodes (N) of the mesh (M) of the adjacent cell (C). Also, the nodes (N) of the mesh (M) of a cell (C) located at a common boundary (B) with an adjacent cell (C) are also nodes (N) of the mesh (M) of the adjacent cell (C).

The algorithm used for generating the mesh (M) shown in figure 7B also adds additional nodes located within the space of the cell (C) preventing elements or volumes delimited by the mesh (M) too distorted.

The resulting mesh (M) of each cell (C) is merged to the global mesh (M), consolidating the duplicated nodes (N) between adjacent cells (C). When a mesh (M) located in a cell (C) and a mesh (M) located in an adjacent cell (C) has a common node (N), the duplicated nodes (N) are simplified keeping only a single node (N).

In this embodiment, the mesh (M) generated uses zero-thickness elements when representing the geophysical entities (E) since they represent fractures or discontinuities on properties.

This consolidating operation does not act over double nodes of the zero-thickness elements keeping said double nodes.

Once the global mesh (M) is generated from the union of the meshes of each cell (C), the global mesh (M) is split using the segments of the representation of the geophysical entities (E).

Figure 7C shows a discretization using finite elements and wherein the geophysical entities (E) are approximated by using zero-thickness elements. The global mesh (M) is represented by splitting the reservoir domain (Ω) according to the four regions defined by the zero-thickness elements. On each mesh node (N) properties that relate it to the input geophysical entities (E) that originated the node (N) are retained.

The method of the present invention allows the modification of certain regions of the mesh (M) without having to re-mesh the whole domain (Ω). As long as the mesh (M) is created at the cell (C) level, all the necessary information to perform this operation is stored in the cell (C) or in a data base linked to the cell (C). Considering this fact, each cell (C) could be considered as an independent meshing problem that uses the cells (C) resulting from the division/analysis processes. This allows the modification of the mesh (M) in certain regions without affecting the whole domain, saving time and computational resources while keeping the good conditioning properties of the resulting mesh (M).

Based on the previous example, once the reservoir domain (Ω) is partitioned and meshed, a modification is required in a certain region. This modification changes the properties of a region of the domain (Ω) and those cells (C) housing at least part of said modified region are removed from the partition (P) and, the void space is filled with a new set of cells (C).

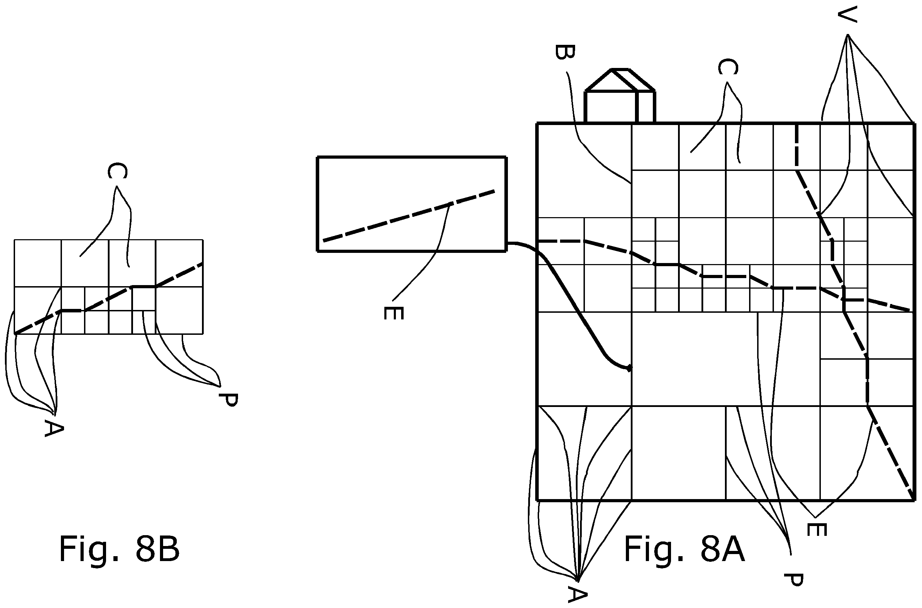

From the partition (P) of the reservoir domain (Ω) from the previous example a set of cells (C) are required to be modified. Figure 8A shows the partition (P) from figure 6B with a void region and a new region with an updated geophysical entity (E) to be inserted in the void region of the reservoir domain (Ω).

Figure 8B shows the partition (P) of the new region and the approximation of the geophysical entity (E) housed in the cells (C) of the partition (P) that will be inserted into the initial domain (Ω). The partition (P) comprises a plurality of cells (C) and the partition process of the region follows the criteria explained in the previous example.

Once the new region to be inserted is partitioned and all the conditions causing a refinement are no met, the geometry of the geophysical entity (E) housed in the cells (C) is approximated with an error below a predetermined value. The geophysical entity (E) is represented by portions extended between the active points (A) in each cell (C). The dashed lines in figure 8B represent the approximation of the geophysical entity (E) by portions of lines in the new region.

According to this embodiment, once the new region is partitioned and the geometry of the geophysical entity (E) is approximated, the new region is inserted into the original domain (Ω). According to another embodiment, the refining process of the cells (C) by partitioning the new block is done once said block is inserted.

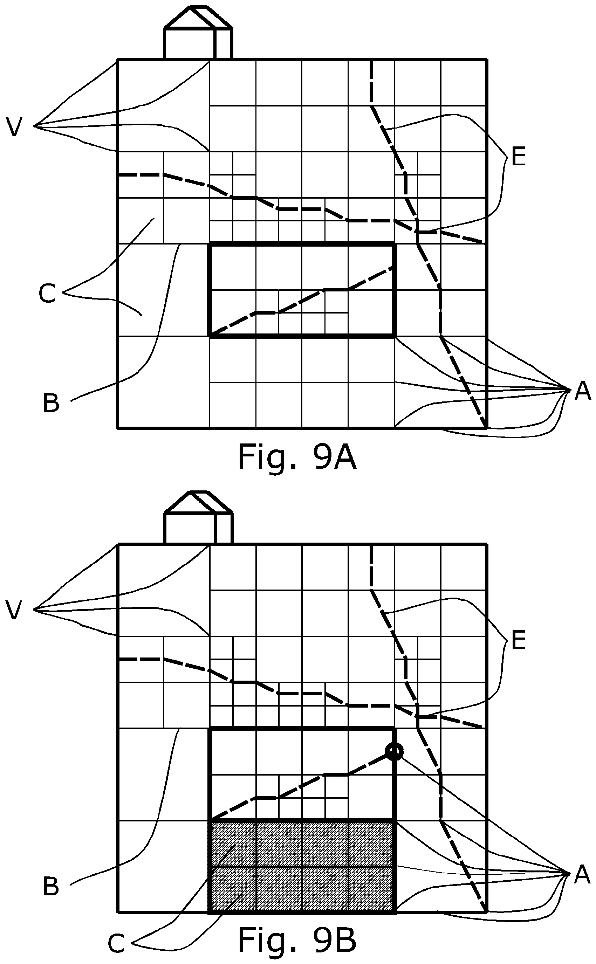

Figure 9A shows the reservoir domain (Ω) filled with the new set of cells (C) replacing the originals.

After including the new block in the domain, the consistency of the division is checked, balancing operations are performed in order to fulfill the criteria of the refinement explained before and active points (A) representing the geophysical entity (E) are included to guarantee the continuity. This process extends the refinement of the cells (C) over a surrounding region resulting in a limited influence of the new block and therefore, avoiding to replace the entire previously generated mesh (M), if any, or previously generated cells (C).

The filled cells (C) shown in figure 9B using a gray pattern represent the cells (C) that have been subdivided due to balancing fulfilling the criteria of the refinement, and the circle represents a new active point (A) used to approximate the new geophysical entity (E). The new active point (A) representing the geophysical entity (E) introduced is a new node (N) of the mesh (M).

As it can be seen in figure 9B, some cells (C) from the bottom of the domain (Ω) have been subdivided due to the new partition (P) of the region introduced. The refinement of these cells (C) is necessary in order to maintain the relationship 2:1 of the size between adjacent cells (C).

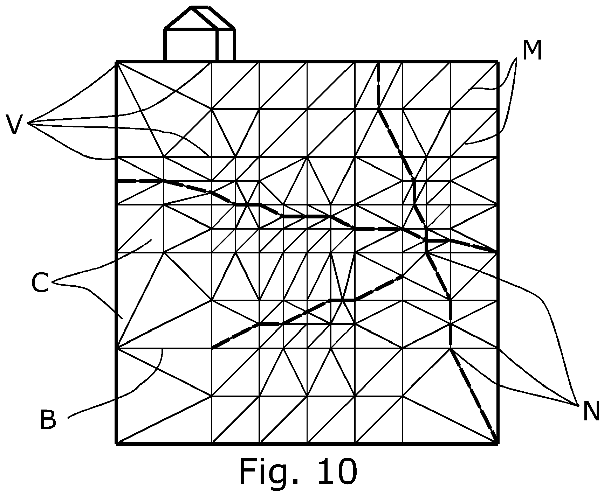

Figure 10 shows the global mesh (M) of the domain (Ω) according to the previous replacement.

The method of the present invention allows the modification of certain regions of the mesh (M) without having to re-mesh the whole domain (Ω). Each cell (C) is meshed at a cell level and the necessary information is stored in the cell (C). Therefore, only those modified cells (C) have to re-generate their meshes (M). The cells (C) that have not been affected keep their meshes (M).

Once the new region is inserted into the initial domain (Ω) and the consistency of the division is checked, the modified cells (C) comprises individual meshes (M) and their meshes (M) are merged into the global mesh (M).

In the new global mesh (M) from figure 10, it can be seen the new nodes (N) of the mesh (M) determined from the active points (A) not being located at any vertex representing the geophysical entity (E) introduced in the replacement.

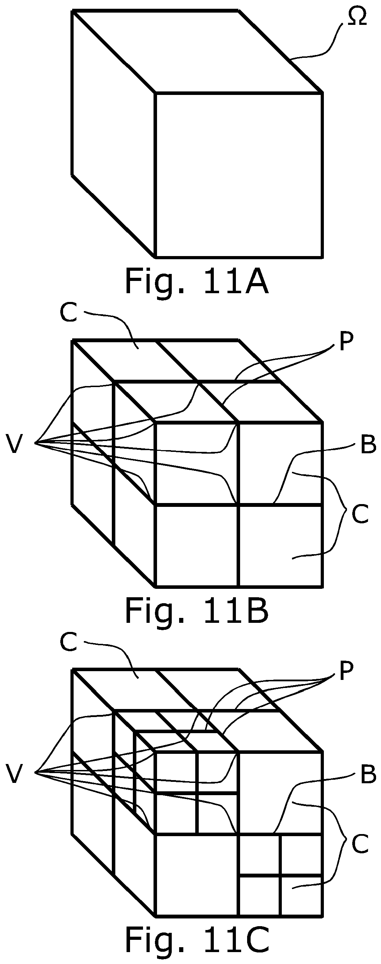

Figures 11A to 11C show a 3D-domain example with its corresponding partition (P) in a plurality of cells (C).

Figure 11A shows a reservoir domain (Ω) in three dimensions. Figure 11B shows a first partition (P) of the 3D-domain (Ω). According to this example, the domain (Ω) is partitioned in a plurality of cells (C). The cells are hexahedrons with the faces parallel two by two. Figure 11C shows the refinement of some cells (C) from the previous partition (P). In this example, a cell or sub-cell (C) is refined by subdividing each dimension into two parts by half resulting eight sub-cells (C). Each cell (C) is limited by a boundary (B) and has eight vertices (V).

## Claims

1. Computer implemented method for manipulating a mesh for the discretization of a reservoir domain modeled by a geophysical model, a fluid model or both models, wherein the geophysical model comprises the mechanical and rock properties and the fluid model comprises the fluid properties and, both models comprise geophysical entities of the reservoir; the information data of geophysical entities being retrieved from the reservoir,
the method comprising:
a) generating, via a computer system, a geophysical model (GM), a fluid model (FM) or both models (GM, FM), said models (GM, FM) comprising geophysical entities (E) in the domain (Ω);
b) generating, via a computer system, a partition (P) of the domain (Ω), the partition (P) comprising a plurality of cells (C) limited by a boundary (B), each cell (C) comprising vertices (V) and, each cell (C) has a common boundary (B) with adjacent cells (C);
c) generating for each cell (C), via a computer system, a numerical mesh (M) discretizing the cell (C), said numerical mesh (M) comprising nodes (N) at least in the vertices (V) of the cell (C);
d) providing the mesh (M) resulting from the union of the meshes (M) of the plurality of cells (C), that is, the result of a consolidation process removing the duplicated nodes of adjacent cells and to store the nodes in the global mesh only once wherein duplicated nodes are at locations separated by a distance lower than a predetermined threshold;
wherein the cells (C) of the partition (P), have a shape that, when a cell (C) is subdivided into smaller sub-cells (C), said sub-cells (C) have the same topology than the original (C), and wherein the set of cells (C) are rectangles if the domain (Ω) is a 2D-domain or hexahedrons if the domain (Ω) is a 3D-domain, with the edges/faces parallel two by two;
the method being adapted for the simulation of oil and gas reservoirs, reproducing an exploitation process as many times as needed for identifying the optimal exploitation plan, said optimal plan being the exploitation plan of the exploitation process.

2. A method according to claim 1, wherein for each common boundary (B) between a cell (C) and an adjacent cell (C), vertices (V) included in the common boundary of the cell (C) limiting the common boundary (B) are nodes (N) of the mesh (M) of the adjacent cell (C).

3. A method according to any of previous claims, given a predetermined cell (C), those nodes (N) of the mesh (M) of adjacent cells (C) located at the common boundary (B) between the cell (C) and the adjacent cell (C) are also nodes (N) of the mesh (M) of the cell (C).

4. A method according to any of previous claims, wherein each cell (C) comprises a plurality of active points (A) at a predetermined locations of the boundary of the cell (C), being the active points (A) the points of the cell (C) that are candidate locations allowed to be a node (N) of the mesh (M).

5. A method according to any of previous claims, wherein a cell (C) or a sub-cell (C) of the partition (P) is refined by subdividing each dimension into two parts by half resulting 2*^{N}* sub-cells (C) where *N* is the number of dimensions, the new sub-cells (C) being part of the partition (P).

6. A method according to claim 5, wherein if a cell (C) being subdivided has a mesh (M), said mesh (M) is removed before subdividing the cell (C) and a new mesh (M) is reconstructed at least in the new sub-cells (C) after subdividing the cell (C).

7. A method according to claim 5 or 6, wherein a cell (C) is iteratively refined under:
- a first criterion based on the number of divisions of the adjacent cells (C), that is, the cell (C) is refined if the number of divisions of the adjacent cells (C) in the common boundary (B) is greater than a predetermined value, preferably 2; or,
- a second criterion based on the number of geophysical entities (E) housed in the cell (C), that is, the cell (C) is refined if the number of geophysical entities (E) housed or partially housed in the cell (C) is greater than a predetermined value, preferably 2; or,
- a third criterion based on the distance of the intersection of a geophysical entity (E), at least partially housed in the cell (C), with the boundaries (B) of the cell (C) and the active points (A) of said cell (C), that is, the cell (C) is refined if the minimum distance between the intersection of a geophysical entity (E) with the boundaries (B) and the active points (A) of said cell (C) is greater than a predetermined value; or,
- any combination thereof;
until none of the previous options is fulfilled.

8. A method according to any of previous claims, wherein in each refining operation of cells (C), in those common boundaries (B) of a cell (C) adjacent to cell (C) boundaries (B) limiting two or more sub-cells (C) the method further adds at least a new node (N) at the location of the intersection of the common boundary (B) of the cell (C) and the boundaries (B) limiting the two or more sub-cells (C).

9. A method according to any of previous claims wherein, after generating the partition (P) or after generating the partition (P) and one or more meshes (M) in cells (C), the method comprises:
- modifying the geophysical model (GM), the fluid model (FM) or both models (GM, FM);
- identifying at least one updated cell (C), that is, a cell (C) housing geophysical entities (E) with modified data;
- removing the at least one updated cell (C) from the partition (P);
- filling the space of the domain (Ω) with a new cell or cells (C).

10. A method according to any of previous claims wherein, each cell (C) further stores data of the geophysical entities (E) being housed in said cell (C).

11. A method according to claims 9 or 10, wherein after filing the space of the domain (Ω) with a new cell or new cells (C),
- the new cell or cells (C) are refined according to any of claims 5 to 8;
- a new mesh (M) is generated in each updated cell or cells (C); and
- the mesh (M) is updated according to claim 9.

12. A computer readable medium storing computer-executable instructions which, when executed by a processor, result in the method of any one of claims 1 toll.

13. An electronic device for data analysis, the device comprising:
- a processor; and
- a computer readable medium storing computer-executable instructions which, when executed by the processor, result in the method of any one of claims 1 to 11.

## Patentansprüche

1. Computerimplementiertes Verfahren zum Manipulieren eines Netzes für die Diskretisierung eines Reservoirbereichs, der durch ein geophysikalisches Modell, ein Fluidmodell oder beide Modelle modelliert ist, wobei das geophysikalische Modell die mechanischen und Gesteinseigenschaften umfasst und das Fluidmodell die Fluideigenschaften umfasst und beide Modelle geophysikalische Entitäten des Reservoirs umfassen; wobei die Informationsdaten der geophysikalischen Entitäten abgerufen werden aus dem Reservoir,
wobei das Verfahren umfasst:
a) Erzeugen, über ein Computersystem, eines geophysikalischen Modells (GM), eines Fluidmodells (FM) oder beider Modelle (GM, FM), wobei die Modelle (GM, FM) geophysikalische Entitäten (E) in dem Bereich (Ω) umfassen;
b) Erzeugen, über ein Computersystem, einer Partition (P) des Bereichs (Ω), wobei die Partition (P) eine Vielzahl von Zellen (C) umfasst, die durch eine Grenze (B) begrenzt sind, jede Zelle (C) eine gemeinsame Grenze (B) mit benachbarten Zellen (C) aufweist;
c) Erzeugen, für jede Zelle (C), über ein Computersystem, eines numerischen Netzes (M), Diskretisieren der Zelle (C), wobei das numerische Netz (M) Knoten (N) mindestens in den Eckpunkten (V) der Zelle (C) umfasst;
d) Bereitstellen des Netzes (M), das aus der Vereinigung der Netze (M) der Vielzahl von Zellen (C) resultiert, d.h. das Ergebnis eines Konsolidierungsprozesses, der die duplizierten Knoten benachbarter Zellen entfernt, und Speichern der Knoten in dem globalen Netz nur einaml, wobei sich duplizierte Knoten an Stellen befinden, die durch einen Abstand getrennt sind, der kleiner als ein vorbestimmter Schwellenwert ist;
Wobei die Zellen (C) in der Partition (P) eine Form aufweisen, die, wenn eine Zelle (C) in kleinere Unterzellen (C) unterteilt ist, die Unterzellen (C) die gleiche Topologie aufweisen wie das Original (C), und wobei der Satz von Zellen (C) Rechtecke sind, falls der Bereich (Ω) ein 2D-Bereich ist, oder Hexaeder, falls der Bereich (Ω) ein 3D-Bereich ist, wobei die Kanten/Flächen parallel zwei mal zwei sind;
wobei das Verfahren für die Simulation von Öl- und Gasreservoirs gestaltet ist, einen Förderungsprozess so viele Male wie nötig zu reproduzieren, um den optimalen Förderungsprozess zu identifizieren, wobei der optimale Plan der Förderungsplan des Förderungsprozesses ist.

2. Verfahren nach Anspruch 1, wobei für jede gemeinsame Grenze (B) zwischen einer Zelle (C) und einer benachbarten Zelle (C) Eckpunkte (V), die in der gemeinsamen Grenze der Zelle (C) enthalten sind, die die gemeinsame Grenze (B) begrenzt, Knoten (N) des Netzes (M) der benachbarten Zelle (C) sind.

3. Verfahren nach einem der vorhergehenden Ansprüche, wobei angesichts einer vorbestimmten Zelle (C) diejenigen Knoten (N) des Netzes (M) benachbarter Zellen (C), die sich an der gemeinsamen Grenze (B) befinden, zwischen der Zelle (C) und der benachbarten Zelle (C) auch Knoten (N) des Netzes (M) der Zelle (C) sind.

4. Verfahren nach einem der vorhergehenden Ansprüche, wobei jede Zelle (C) eine Vielzahl von aktiven Punkten (A) an vorbestimmten Stellen der Grenze der Zelle (C) umfasst, wobei die aktiven Punkte (A) die Punkte der Zelle (C) sind, die Kandidatenstellen sind, die ein Knoten (N) des Netzes (M) sein dürfen.

5. Verfahren nach einem der vorhergehenden Ansprüche, wobei eine Zelle (C) oder eine Unterzelle (C) der Partition (P) verfeinert wird, indem jede Dimension in zwei Hälften unterteilt wird durch resultierende 2^{N}-Unterzellen (C), wobei N die Anzahl der Dimensionen ist, wobei die neuen Unterzellen (C) Teil der Partition (P) sind.

6. Verfahren nach Anspruch 5, wobei, wenn eine Zelle (C), die unterteilt wird, ein Netz (M) aufweist, das Netz (M) vor dem Unterteilen der Zelle (C) entfernt wird und ein neues Netz (M) zumindest in den neuen Unterzellen (C) nach dem Unterteilen der Zelle (C) rekonstruiert wird.

7. Verfahren nach Anspruch 5 oder 6, wobei eine Zelle (C) iterativ verfeinert wird unter:
- einem ersten Kriterium, das auf der Anzahl der Unterteilungen der benachbarten Zellen (C) basiert, das heißt, die Zelle (C) wird verfeinert, wenn die Anzahl der Unterteilungen der benachbarten Zellen (C) in der gemeinsamen Grenze (B) größer als ein vorbestimmter Wert ist, vorzugsweise 2; oder
- einem zweiten Kriterium, das auf der Anzahl der geophysikalischen Entitäten (E) basiert, die in der einem zweiten Kriterium, das auf der Anzahl der geophysikalischen Entitäten (E) basiert, die in der Zelle (C) enthalten sind, das heißt, die Zelle (C) wird verfeinert, wenn die Anzahl der geophysikalischen Entitäten (E), die in der Zelle (C) enthalten oder teilweise enthalten sind, größer als ein vorbestimmter Wert ist, vorzugsweise 2; oder
- einem dritten Kriterium, das auf dem Abstand des Schnittpunkts einer geophysikalischen Entität (E) basiert, die zumindest teilweise in der Zelle (C) enthalten ist, mit den Grenzen (B) der Zelle (C) und den aktiven Punkten (A) der Zelle (C), das heißt, die Zelle (C) wird verfeinert, wenn der Mindestabstand zwischen dem Schnittpunkt einer geophysikalischen Entität (E) mit den Grenzen (B) und den aktiven Punkten (A) der Zelle (C) größer als ein vorbestimmter Wert ist; oder
- bis keine der vorhergehenden Optionen erfüllt ist.

8. Verfahren nach einem der vorhergehenden Ansprüche, wobei bei jedem Verfeinerungsvorgang von Zellen (C), in jenen gemeinsamen Grenzen (B) einer Zelle (C), die zu Zelle (C) benachbart sind, Grenzen (B) die zwei oder mehr Unterzellen (C) begrenzen, das Verfahren ferner mindestens einen neuen Knoten (N) an der Stelle des Schnittpunkts der gemeinsamen Grenze (B) der Zelle (C) und der Grenzen (B) hinzufügt, die die zwei oder mehr Unterzellen (C) begrenzen.

9. Verfahren nach einem der vorhergehenden Ansprüche, wobei nach dem Erzeugen der Partition (P) oder nach dem Erzeugen der Partition (P) und eines oder mehrerer Netze (M) in Zellen (C) das Verfahren umfasst:
- Modifizieren des geophysikalischen Modells (GM), des Fluidmodells (FM) oder beider Modelle (GM, FM),
- Identifizieren mindestens einer aktualisierten Zelle (C), das heißt, einer Zelle (C), die geophysikalische Entitäten (E) mit modifizierten Daten enthält;
- Entfernen der mindestens einen aktualisierten Zelle (C) aus der Partition (P);
- Füllen des Raums des Bereichs (Ω) mit einer neuen Zelle oder neuen Zellen (C).

10. Verfahren nach einem der vorhergehenden Ansprüche, wobei jede Zelle (C) ferner Daten der geophysikalischen Entitäten (E), die in der Zelle (C) enthalten sind, umfasst.

11. Verfahren nach Anspruch 9 oder 10, wobei nach dem Füllen des Raums des Bereichs (Ω) mit einer neuen Zelle oder neuen Zellen (C),
- die neue Zelle oder neuen Zellen (c) gemäß einem der Ansprüche 5 bis 8 verfeinert werden;
- ein neues Netz (M) in jeder aktualisierten Zelle oder Zellen (C) erzeugt wird; und
- das Netz (M) gemäß Anspruch 9 aktualisiert wird.

12. Computerlesbares Medium, das computerausführbare Anweisungen speichert, die, wenn sie von einem Prozessor ausgeführt werden, zu dem Verfahren nach einem der Ansprüche 1 bis 9 führen.

13. Elektronische Vorrichtung zur Datenanalyse, wobei die Vorrichtung umfasst:
- einen Prozessor; und
- ein computerlesbares Medium, das computerausführbare Anweisungen speichert, die, wenn sie von dem Prozessor ausgeführt werden, zu dem Verfahren nach einem der Ansprüche 1 bis 11 führen.

## Revendications

1. Procédé mis en oeuvre par ordinateur pour manipuler un maillage pour la discrétisation d'un domaine de gisement modélisé par un modèle géophysique, un modèle de fluide ou les deux modèles, dans lequel le modèle géophysique comprend les propriétés mécaniques et les propriétés de roche et le modèle de fluide comprend les propriétés de fluide et les deux modèles comprennent des entités géophysiques du gisement, les données d'information d'entités géophysiques étant récupérées à partir du gisement,
le procédé comportant de :
a) générer, via un système informatique, un modèle géophysique (GM), un modèle de fluide (FM) ou les deux modèles (GM, FM), lesdits modèles (GM, FM) comportant des entités géophysiques (E) dans le domaine (Ω),
b) générer, via un système informatique, une partition (P) du domaine (Ω), la partition (P) comportant une pluralité de cellules (C) délimitées par une frontière (B), chaque cellule (C) comportant des sommets (V) et chaque cellule (C) ayant une frontière (B) commune avec des cellules (C) adjacentes,
c) générer pour chaque cellule (C), via un système informatique, un maillage numérique (M) discrétisant les cellules (C), ledit maillage numérique (M) comportant de noeuds (N) au moins aux sommets (V) de la cellule (C),
d) fournir le maillage (M) résultant de l'union des maillages (M) de la pluralité de cellules (C), c'est-à-dire le résultat d'un processus de consolidation retirant les noeuds dupliqués de cellules adjacentes et stocker une seule fois les noeuds dans le maillage global, dans lequel des noeuds dupliqués sont à des emplacements séparés par une distance inférieure à un seuil prédéterminé,
dans lequel les cellules (C) de la partition (P) ont une forme qui, lorsqu'une cellule (C) est subdivisée en sous-cellules (C) plus petites, lesdites sous-cellules (C) ont la même topologie que l'originale (C), et dans lequel les cellules de l'ensemble de cellules (C) sont des rectangles si le domaine (Ω) est un domaine 2D ou des hexaèdres si le domaine (Ω) est un domaine 3D, avec des arêtes/faces parallèles deux à deux,
le procédé étant adapté pour la simulation de gisements de pétrole et de gaz, en reproduisant un processus d'exploitation autant de fois que nécessaire pour identifier le plan d'exploitation optimal, ledit plan optimal étant le plan d'exploitation du processus d'exploitation.

2. Procédé selon la revendication 1, dans lequel pour chaque frontière (B) commune entre une cellule (C) et une cellule (C) adjacente, des sommets (V) inclus dans la frontière commune de la cellule (C) délimitant la frontière (B) commune sont des noeuds (N) du maillage (M) de la cellule (C) adjacente.

3. Procédé selon l'une quelconque des revendications précédentes, dans lequel pour une cellule (C) prédéterminée, les noeuds (N) du maillage (M) de cellules (C) adjacentes situées sur la frontière (B) commune entre la cellule (C) et la cellule (C) adjacente sont également des noeuds (N) du maillage (M) de la cellule (C).

4. Procédé selon l'une quelconque des revendications précédentes, dans lequel chaque cellule (C) comprend une pluralité de points actifs (A) à des emplacements prédéterminés de la frontière de la cellule (C), les points actifs (A) étant les points de la cellule (C) qui sont des emplacements candidats autorisés à être un noeud (N) du maillage (M).

5. Procédé selon l'une quelconque des revendications précédentes, dans lequel une cellule (C) ou une sous-cellule (C) de la partition (P) est affinée en subdivisant chaque dimension en deux parties pour obtenir 2^{N} sous-cellules (C), où N est le nombre de dimensions, les nouvelles sous-cellules (C) étant une partie de la partition (P).

6. Procédé selon la revendication 5, dans lequel si une cellule (C) étant subdivisée a un maillage (M), ledit maillage (M) est retiré avant de subdiviser la cellule (C) et un nouveau maillage (M) est reconstruit au moins dans les nouvelles sous-cellules (C) après subdivision de la cellule (C).

7. Procédé selon la revendication 5 ou 6, dans lequel une cellule (C) est affinée de manière itérative par :
a) un premier critère basé sur le nombre de divisions des cellules (C) adjacentes, c'est-à-dire que la cellule est affinée si le nombre de divisions des cellules (C) adjacentes à la frontière (B) commune est supérieur à une valeur prédéterminée, de préférence 2, ou
b) un deuxième critère basé sur le nombre d'entités géophysiques (E) reçues dans la cellule (C), c'est-à-dire que la cellule (C) est affinée si le nombre d'entités géophysiques (C) reçues ou partiellement reçues dans la cellule (C) est supérieur à une valeur prédéterminée, de préférence 2, ou
c) un troisième critère basé sur la distance de l'intersection d'une entité géophysique (E), au moins partiellement reçue dans la cellule (C), avec les frontières (B) de la cellule (C) et les points actifs (A) de ladite cellule (C), c'est-à-dire que la cellule (C) est affinée si la distance minimale entre l'intersection d'une entité géophysique (E) avec les frontières (B) et les points actifs (A) de ladite cellule (C) est supérieure à une valeur prédéterminée, ou
une combinaison quelconque de ceux-ci,
jusqu'à ce qu'aucune des options précédentes ne soit satisfaite.

8. Procédé selon l'une quelconque des revendications précédentes, dans lequel dans chaque opération d'affinage des cellules (C), dans ces frontières (B) communes d'une cellule (C) adjacente à des frontières (B) de cellules (C) délimitant deux sous-cellules (C) ou plus, le procédé ajoute en outre au moins un nouveau noeud (N) à l'emplacement de l'intersection de la frontière (B) commune de la cellule (C) et des frontières (B) délimitant les deux sous-cellules (C) ou plus.

9. Procédé selon l'une quelconque des revendications précédentes, dans lequel, après la génération de la partition (P) ou après la génération de la partition (P) et d'un ou plusieurs maillages (M) dans des cellules (C), le procédé comprend :
a) modifier le modèle géophysique (GM), le modèle de fluide (FM) ou les deux modèles (GM, FM),
b) identifier au moins une cellule (C) mise à jour, c'est-à-dire une cellule (C) recevant des entités géophysiques (E) avec des données modifiées,
c) retirer la au moins une cellule (C) mise à jour de la partition (P),
d) remplir l'espace du domaine (Ω) avec une nouvelle cellule ou des nouvelles cellules (C).

10. Procédé selon l'une quelconque des revendications précédentes, dans lequel chaque cellule (C) stocke en outre des données des entités géophysiques (E) étant reçues dans ladite cellule (C).

11. Procédé selon les revendications 9 ou 10, dans lequel après le remplissage de l'espace du domaine (Ω) avec une nouvelle cellule ou de nouvelles cellules (C),
- la nouvelle cellule ou les nouvelles cellules (C) sont affinées selon l'une quelconque des revendications 5 à 8,
- un nouveau maillage (M) est généré dans chaque cellule ou chacune des cellules (C) mises à jour, et
- le maillage (M) est mis à jour selon la revendication 9.

12. Support lisible par ordinateur stockant des instructions exécutables par ordinateur qui, lorsqu'elles sont exécutées par un processeur, ont pour résultat le procédé de l'une quelconque des revendications 1 à 11.

13. Dispositif électronique pour l'analyse de données, le dispositif comprenant :
- un processeur ; et
- un support lisible par ordinateur stockant des instructions exécutables par ordinateur qui, lorsqu'elles sont exécutées par le processeur, ont pour résultat le procédé de l'une quelconque des revendications 1 à 11.
